# EUROPEAN PATENT APPLICATION

(11) **EP 4 697 903 A1**
(43) Date of publication of application: **18.02.2026**
(21) Application number: 25194796.6
(22) Date of filing: 08.08.2025
(51) Int. Cl.: H10H 20/01, H10H 29/01, H10H 29/03, H10H 29/30

(54) **MASK MEMBER, LIGHT EMITTING ELEMENT TRANSFER DEVICE, AND METHOD OF TRANSFERRING THE LIGHT EMITTING ELEMENT**

(30) Priority: 13.08.2024 KR 20240108254
(71) Applicant: Samsung Display Co., Ltd., Yongin-si, Gyeonggi-do 17113 (KR)
(72) Inventor: KIM, Jong Hyup, Yongin-si (KR); KIM, Dong Sul, Yongin-si (KR); KIM, Jae Han, Yongin-si (KR); JOO, Eun Chong, Yongin-si (KR); CHOI, Eun Sun, Yongin-si (KR)
(74) Representative: Marks & Clerk LLP

(57) **Abstract**

A mask member, a light emitting element transfer device, and a transfer method are provided. A mask member includes a first mask including a light blocking pattern layer and a base layer, wherein the light blocking pattern layer of the first mask includes a plurality of opening patterns, and a second mask including a light blocking pattern layer and a base layer, wherein the light blocking pattern layer of the second mask includes a plurality of opening patterns disposed at angles relative to a center of the second mask. The mask member defining a transfer area by overlapping an opening pattern of the plurality of opening patterns of the first mask and an opening pattern of the plurality of opening patterns of the second mask.

## Description

### BACKGROUND

### 1. Field

The present disclosure relates to a mask member, a light emitting element transfer device, and a method of transferring the light emitting element.

### 2. Description of the Related Art

The importance of display devices is increasing along with the development of multimedia. In response, several types of display devices are being used, such as, for example, organic light-emitting displays (OLED) and liquid crystal displays (LCD).

A device for displaying an image of a display device includes a display panel such as, for example, a light-emitting display panel or a liquid crystal display panel. Among such display panels, the light-emitting display panel may include a light-emitting diode (LED). The light-emitting diode includes an organic light-emitting diode using an organic material as a fluorescent material or an inorganic light-emitting diode using an inorganic material as a fluorescent material.

In the manufacturing of display panel that uses inorganic light-emitting diodes as light-emitting diodes, a process is desired to grow a micro LED on a semiconductor substrate and then transfer the micro LED onto the display panel substrate.

### SUMMARY

Aspects and features of embodiments of the present disclosure provide a mask member, a light emitting element transfer device, and a transfer method suitable for a circular cell shape.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

According to an embodiment, a mask member includes a first mask including a light blocking pattern layer and a base layer, wherein the light blocking pattern layer of the first mask includes a plurality of opening patterns, and a second mask including a light blocking pattern layer and a base layer, wherein the light blocking pattern layer of the second mask includes a plurality of opening patterns disposed at angles relative to a center of the second mask, wherein the mask member defines a transfer area by overlapping an opening pattern of the plurality of opening patterns of the first mask and an opening pattern of the plurality of opening patterns of the second mask.

In an embodiment, the plurality of opening patterns of the first mask are disposed at angles relative to a center of the first mask, and the plurality of opening patterns of the first mask and the plurality of opening patterns of the second mask are left-right symmetrical.

In an embodiment, respective shapes of the opening patterns of the second mask may be different from one another.

In an embodiment, the opening pattern of the second mask is a polygon having a square shape or a curved shape.
In an embodiment, the base layer may have a flat plate shape formed of a transparent material and have light-transmitting properties, wherein the light blocking pattern layer of the first mask includes a material having light-blocking properties in a region of the first mask different from the plurality of opening patterns, and the light blocking pattern layer of the second mask includes the material having light-blocking properties in a region of the second mask different from the plurality of opening patterns.

In an embodiment, the first mask and the second mask are each rotatably disposed mask members.

In an embodiment, the opening pattern of the plurality of opening patterns of the first mask has a single row shape, each of the plurality of opening patterns of the second mask has a size and shape corresponding to a single chip.

According to an embodiment, a transfer device for transferring a light emitting element includes a laser emitting member, a support member disposed under the laser emitting member and supporting a target substrate, and a mask member disposed between a donor substrate disposed on the target substrate and the laser emitting member and defining a laser transfer area. The mask member includes: a first mask including a light blocking pattern layer and a base layer, wherein the light blocking pattern layer of the first mask includes a plurality of opening patterns, and a second mask including a light blocking pattern layer and a base layer, wherein the light blocking pattern layer of the second mask includes a plurality of opening patterns disposed at angles relative to a center of the second mask, wherein the transfer device defines the laser transfer area by overlapping an opening pattern of the plurality of opening patterns of the first mask and an opening pattern of the plurality of opening patterns of the second mask.

In an embodiment, the plurality of opening patterns of the first mask are disposed at angles relative to a center of the first mask, and the plurality of opening patterns of the first mask and the plurality of opening patterns of the second mask are left-right symmetrical.

In an embodiment, respective shapes of the opening patterns of the second mask may be different from one another.

In an embodiment, the opening pattern of the second mask is a polygon having a square shape or a curved shape.

In an embodiment, the base layer may have a flat plate shape formed of a transparent material and have light-transmitting properties, wherein the light blocking pattern layer of the first mask includes a material having light-blocking properties in a region of the first mask different from the plurality of opening patterns, and the light blocking pattern layer of the second mask includes the material having light-blocking properties in a region of the second mask different from the plurality of opening patterns.

In an embodiment, the first mask and the second mask are each rotatably disposed mask members.

In an embodiment, the target substrate includes a plurality of cell areas for forming a plurality of display panels, and the plurality of cell areas are circular.

In an embodiment, the opening pattern of the plurality of opening patterns of the first mask has a single row shape, wherein each of the plurality of opening patterns of the second mask has a size and shape corresponding to a single chip.
According to an embodiment, the method of transferring a light emitting element includes checking, by a controller, shapes of opening patterns of a first mask and shapes of opening patterns of a second mask in association with finding an opening pattern having a shape identical to a shape of a transfer target area of a target substrate, rotating, by the controller, at least one of the first mask and the second mask such that an opening pattern of the first mask overlaps a widest opening pattern among the opening patterns of the second mask, wherein the shape of the opening pattern of the first mask is identical to the shape of the transfer target area, and irradiating, by emitting a laser, the opening pattern of the first mask and the widest opening pattern of the second mask which are overlapping.

In an embodiment, the method further includes moving, by the controller, the mask member to a next transfer target area.

In an embodiment, the opening pattern is irradiated with the laser at a temporal instance when the opening pattern of the first mask and the widest opening pattern of the second mask overlap and are disposed in a straight line.

In an embodiment, the plurality of opening patterns of the first mask are disposed at angles relative to a center of the first mask and the plurality of opening patterns of the second mask are disposed at angles relative to a center of the second mask, and the plurality of opening patterns of the first mask and the plurality of opening patterns of the second mask are left-right symmetrical.

In an embodiment, respective shapes of the opening patterns of the second mask may be different from one another, and the opening pattern of the second mask is a polygon having a square shape or a curved shape.

According to one embodiment, a light emitting element may be transferred appropriately to a circular cell using a mask.

However, the effects of the present disclosure are not limited to the aforementioned effects, and various other effects are included in the present specification.

At least some of the above and other features of the invention are set out in the claims.

### BRIEF DESCRIPTION OF THE DRAWINGS

FIG. 1 is a layout drawing illustrating a display device according to an embodiment.
FIG. 2 is an example drawing illustrating one example of the pixel of FIG. 1.
FIG. 3 is an example drawing illustrating another example of the pixels of FIG. 1.
FIG. 4 is a cross-sectional view illustrating one example of a display panel cut along A-A' of FIG. 2.
FIG. 5 is a plan view illustrating a wafer.
FIG. 6 is a schematic diagram schematically illustrating a light emitting element transfer device.
FIG. 7 is a drawing to illustrate the operation of a light emitting element transfer device.
FIG. 8 is a plan view illustrating a square-shaped cell and a square opening pattern.
FIG. 9 is a plan view illustrating a circular cell and a square opening pattern.
FIG. 10 is a plan view illustrating examples of various opening patterns corresponding to a circular cell C2 of the present disclosure.
FIG. 11 is a plan view to illustrate a mask member according to an embodiment.
FIG. 12 is a flow chart to illustrate a transfer method of a light emitting element according to an embodiment.
FIGS. 13 to 15 are example drawings to illustrate a transfer method using the mask member of FIG. 12.
FIG. 16 is a plan view to illustrate a mask member according to another embodiment.
FIG. 17 is an example drawing to illustrate a transfer method using the mask member of FIG. 16.
FIG. 18 is a plan view to illustrate a mask member according to another embodiment.
FIG. 19 is an example drawing to illustrate a transfer method using the mask member of FIG. 18.

### DETAILED DESCRIPTION

The advantages and features of the present disclosure, and the methods for achieving them, will become clear with reference to the embodiments described in detail below with the accompanying drawings. However, the present disclosure is not limited to the embodiments disclosed below, but may be implemented in various different forms, and the example embodiments are provided to completely disclose the present disclosure. In some aspects, the present disclosure is provided to fully inform those skilled in the art to which the present disclosure belongs of the scope of the disclosure, and aspects of the present disclosure are defined by the scope of the claims.

When an element or layer is referred to as "on" another element or layer, it includes all cases where another layer or another element is interposed directly on or in the middle of the other element. The same reference numerals refer to the same components throughout the specification. The shapes, sizes, ratios, angles, numbers, and other characteristics disclosed in the drawings for explaining the embodiments are examples, and therefore the present disclosure is not limited to the matters illustrated.

Terms such as, for example, "first," "second," and the like may be used to describe various components, but the components should not be limited by the terms. The terms as used herein may distinguish one component from other components and are not to be limited by the terms. For example, without departing the scope of the present disclosure, a first component may be referred to as a second component, and similarly, the second component may also be referred to as the first component. The terms of a singular form may include plural forms unless otherwise specified.

The terminology used herein is for the purpose of describing particular embodiments and is not intended to be limiting. As used herein, "a," "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

The terms "about" or "approximately" as used herein are inclusive of the stated value and include a suitable range of deviation for the particular value as determined by one of ordinary skill in the art, considering the measurement in question and the error associated with measurement of the particular quantity. The term "about" can mean within one or more standard deviations, or within ± 30%, 20%, 10%, 5% of the stated value, for example.

The term "substantially," as used herein, means approximately or actually. The term "substantially equal" means approximately or actually equal. The term "substantially the same" means approximately or actually the same. The term "substantially identical" means approximately or actually identical. The term "substantially perpendicular" means approximately or actually perpendicular.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly.

Embodiments are described herein with reference to cross section illustrations that are schematic illustrations of example embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases.

It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

Specific embodiments will be described herein with reference to the accompanying drawings.

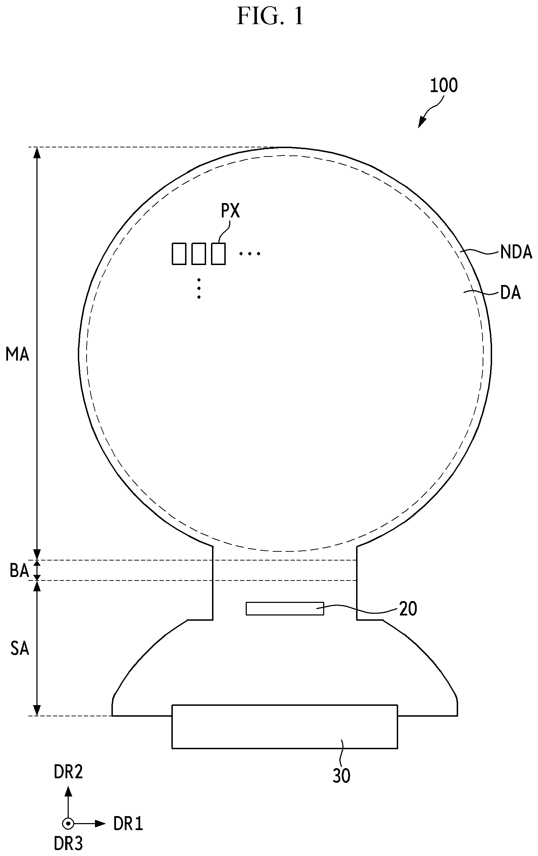

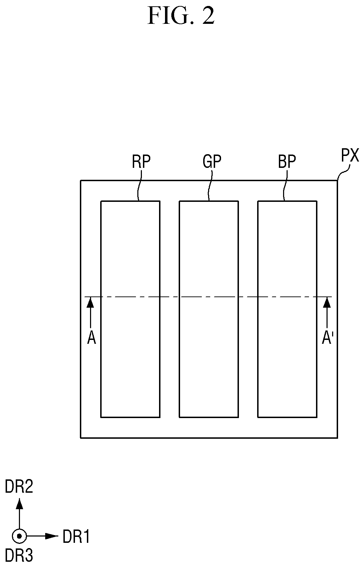

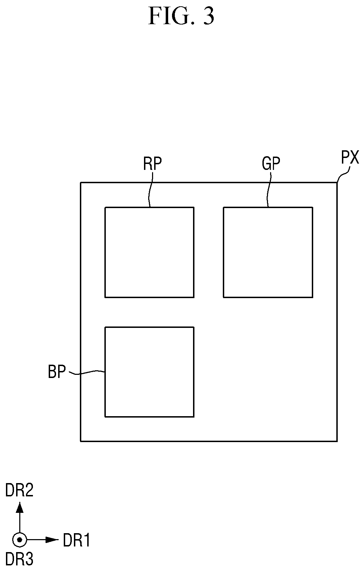

FIG. 1 is a layout diagram illustrating a display device according to an embodiment. FIG. 2 is an example drawing illustrating one example of the pixel of FIG. 1. FIG. 3 is an example drawing illustrating another example of the pixels of FIG. 1.

FIG. 1 illustrates an example where the sub-area SA is unfolded rather than bent.

Referring to FIGS. 1 to 3, the display device is a device that displays a moving image or a still image and is illustrated as an example of a smart watch but is not limited thereto. For example, the display device may be used as a display screen for portable electronic devices such as, for example, a mobile phone, a smart phone, a tablet personal computer, and a watch phone, a mobile communication terminal, a notebook, an e-book, a portable multimedia player (PMP), a navigation device, a ultra mobile PC (UMPC), and the like, as well as a variety of other products such as, for example, a television, a laptop, a monitor, a billboard, an internet of things (IOT) devices, and the like.

The planar shape of the display panel 100 is not limited to a circle and may be formed into another polygon or elliptical shape. The display panel 100 may be formed flat but is not limited thereto. For example, the display panel 100 may be formed at the left and right ends and may include curved portions having a constant or varying curvature. In some aspects, the display panel 100 may be flexibly formed such that it may be bent, curved, folded, or curled.

The display panel 100 may include a display area DA and a non-display area NDA. The display area DA may refer to a portion that displays a screen, and the non-display area NDA may refer to a portion that does not display a screen.

The display area DA may include a circular shape on a plane. However, it is not limited thereto, and the display area DA may have various shapes such as, for example, a square or a square with rounded corners on a plane, a square, other polygons, or an oval.

The non-display area NDA may be disposed around the display area DA. The non-display area NDA may be a bezel area. The non-display area NDA may surround the display area DA. However, it is not limited thereto, and for example, the non-display area NDA may not be disposed in at least some areas of the surrounding areas of the display area DA.

Signal wires or driving circuits for applying signals to the display area DA (display area or touch area) may be disposed in the non-display area NDA. In another embodiment, the non-display area NDA may include a portion of the touch area, and a sensor member such as, for example, a pressure sensor may be disposed in the area.

The display panel 100 may further include pixels PX, scan wires extending in the first direction DR1, and data wires extending in the second direction DR2 for displaying the image. The pixels PX may be arranged in a matrix form in the first direction DR1 and the second direction DR2.

Each of the pixels PX may include a plurality of sub-pixels RP, GP, and BP as illustrated in FIGS. 2 and 3. In FIGS. 2 and 3, each of the pixels PX includes three sub-pixels RP, GP, and BP, namely a first sub-pixel RP, a second sub-pixel GP, and a third sub-pixel BP, but embodiments of the present disclosure are not limited thereto.

The first sub-pixel RP, the second sub-pixel GP, and the third sub-pixel BP may be connected to any one of the data wires, and to at least one of the scan wires among the scan wires.

Each of the first sub-pixel RP, the second sub-pixel GP, and the third sub-pixel BP may have the rectangular, square, or rhombus planar shape. For example, each of the first sub-pixel RP, the second sub-pixel GP, and the third sub-pixel BP may have a rectangular planar shape having a short side in the first direction DR1 and a long side in the second direction DR2 as illustrated in FIG. 2. Alternatively, each of the first sub-pixel RP, the second sub-pixel GP, and the third sub-pixel BP may have the planar shape of a square or rhombus with sides having equal lengths in the first direction DR1 and the second direction DR2 as illustrated in FIG. 3.

As illustrated in FIG. 2, the first sub-pixel RP, the second sub-pixel GP, and the third sub-pixel BP may be arranged in the first direction DR1. Alternatively, one of the second sub-pixel GP and the third sub-pixel BP and the first sub-pixel RP are arranged in the first direction DR1, and the other of the second sub-pixel GP and the first sub-pixel RP may be arranged in the second direction DR2. For example, as illustrated in FIG. 3, the first sub-pixel RP and the second sub-pixel GP may be arranged in the first direction DR1, and the first sub-pixel RP and the third sub-pixel BP may be arranged in the second direction DR2.

Alternatively, one of the first sub-pixel RP and the third sub-pixel BP and the second sub-pixel GP may be arranged in the first direction DR1, and the other of the first sub-pixel RP and the second sub-pixel GP may be arranged in the second direction DR2. Alternatively, one of the first sub-pixel RP and the second sub-pixel GP and the third sub-pixel BP may be arranged in the first direction DR1, and the other one and the third sub-pixel BP may be arranged in the second direction DR2.

The first sub-pixel RP may include a first light-emitting element that emits a first light, the second sub-pixel GP may include a second light-emitting element that emits a second light, and the third sub-pixel BP may include a third light-emitting element that emits a third light. Here, the first light may be light in a red wavelength band, the second light may be light in a green wavelength band, and the third light may be light in a blue wavelength band. The red wavelength band may be a wavelength band of approximately 600µm to 750µm, the green wavelength band may be a wavelength band of approximately 480µm to 560µm, and the blue wavelength band may be a wavelength band of approximately 370µm to 460µm, but embodiments of the present disclosure are not limited thereto.

Each of the first sub-pixel RP, the second sub-pixel GP, and the third sub-pixel BP may include an inorganic light-emitting element having an inorganic semiconductor as the light-emitting element that emits light. For example, the inorganic light emitting element may be a flip chip type micro LED (light-emitting diode), but embodiments of the present disclosure are not limited thereto. For example, an inorganic light emitting element could be a vertical micro-LED (light-emitting diode).

As illustrated in FIGS. 2 and 3, the area of the first sub-pixel RP, the area of the second sub-pixel GP, and the area of the third sub-pixel BP may be substantially the same, but embodiments of the present disclosure are not limited thereto. At least one of the area of the first sub-pixel RP, the area of the second sub-pixel GP, and the area of the third sub-pixel BP may be different from the other. Alternatively, any two of the area of the first sub-pixel RP, the area of the second sub-pixel GP, and the area of the third sub-pixel BP may be substantially the same as each other and be different from the remaining one of the areas. Alternatively, the area of the first sub-pixel RP, the area of the second sub-pixel GP, and the area of the third sub-pixel BP may be different from each other.

The display panel 100 may include a bending area BA, which is an area where the panel is bent. Centering on the bending area BA, the display panel 100 may be divided into a main area MA located on one side of the second direction DR2 of the bending area BA and a sub area SA located on the other side of the second direction DR2 of the bending area BA.

The display area of the display panel 100 is disposed within the main area MA. In an embodiment, the peripheral edge portion of the display area in the main area MA, the entire bending area BA, and the entire sub-area SA may be non-display areas. However, this is not limited thereto, and the bending area BA and/or the sub-area SA may also include a display area.

If at least one edge of the remaining edges of the main area MA excluding the edge connected to the bending area BA is curved or bent, a display area may also be disposed on the corresponding edge. However, without limitation, the curved or bent edge may become a non-display area that does not display the screen, or the display area and the non-display area may be mixed in that area.

The bending area BA is connected to the other side of the main area MA in the second direction DR2. For example, the bending area BA may be connected through the lower short side of the main area MA. The width of the bending area BA (the width in the first direction DR1) may be smaller than the width of the main area MA adjacent to the bending area BA (the width in the first direction DR1). The connection between the main area MA and the bending area BA may have an L-shaped cutting shape.

In the bending area BA, the display panel 100 may be bent with a curvature in the downward direction in the thickness direction, i.e., in the opposite direction of the display surface. The bending area BA may have a constant radius of curvature but is not limited thereto and may have different radii of curvature for each section. As the display panel 100 is bent in the bending area BA, the surface of the display panel 100 may be reversed. That is, one side of the display panel 10 facing upward may change to face outward through the bending area BA and then face downward again.

The sub-area SA extends from the bending area BA. The sub-area SA may extend in a direction parallel to the main area MA starting from after the bending is completed. The sub-area SA may overlap the main area MA in the thickness direction of the display panel 100. The width of the sub-area SA (the width in the first direction DR1) may increase with distance from the bending area BA but is not limited thereto.

A driving chip 20 may be disposed in the sub-area SA. The driving chip 20 may include an integrated circuit that drives the display panel 100. The integrated circuit may include an integrated circuit for a display and/or an integrated circuit for a touch unit. However, embodiments of the present disclosure are not limited thereto, and the integrated circuit for a display and the integrated circuit for a touch unit may be provided as separate chips or may be provided integrated into single chip.

A pad portion may be disposed at an end of a sub-area SA of the display panel 100. The pad portion may include a plurality of display signal wiring pads and touch signal wiring pads. A driving substrate 30 may be connected to the pad portion at an end of the sub-area SA of the display panel 100. The driving substrate 30 may be a flexible printed circuit board or a film.

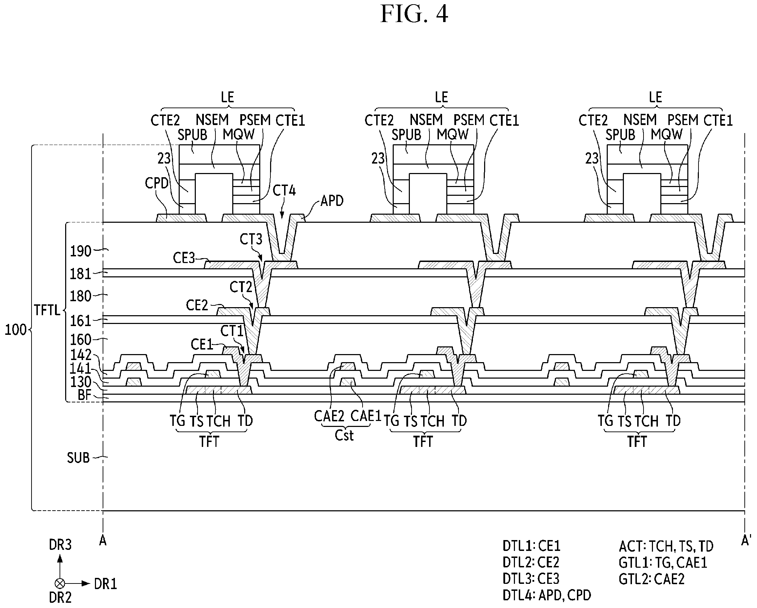

FIG. 4 is a cross-sectional view illustrating one example of a display panel cut along A-A' of FIG. 2.

Referring to FIG. 4, the display panel 100 may include a thin film transistor layer TFTL and light emitting elements LE disposed on a substrate SUB. The thin film transistor layer TFTL may be a layer in which thin film transistors TFT are formed.

The thin film transistor layer TFTL may include an active layer ACT, a first gate layer GTL1, a second gate layer GTL2, a first data metal layer DTL1, a second data metal layer DTL2, a third data metal layer DTL3, and a fourth data metal layer DTL4. Further, the thin film transistor layer TFTL includes a buffer film BF, a gate insulation film 130, a first interlayer insulation film 141, a second interlayer insulation film 142, a first planarization film 160, a first insulation film 161, a second planarization film 180, and a second insulation film 181.

The substrate SUB may be a base substrate or base member for supporting the display device. The substrate SUB may be a rigid substrate formed of glass, but embodiments of the present disclosure are not limited thereto. The substrate SUB may be a flexible substrate that may be bent, folded, rolled, or the like. In this case, the substrate may include an insulating material such as, for example, a polymeric resin such as, for example, polyimide PI.

The buffer film BF may be disposed on one side of the substrate SUB. The buffer film BF may be a film for preventing the penetration of air or moisture. The buffer film BF may include a plurality of inorganic films stacked in alternating layers. For example, the buffer film may be formed as a plurality of alternately stacked inorganic films of one or more of a silicon nitride layer, a silicon oxynitride layer, a silicon oxide layer, a titanium oxide layer, and an aluminum oxide layer. The buffer film BF may be omitted.

The active layer ACT may be disposed on the buffer film BF. The active layer ACT may include a silicon semiconductor, such as, for example, polycrystalline silicon, single crystal silicon, low temperature polycrystalline silicon, and amorphous silicon, or may include an oxide semiconductor.

The active layer ACT may include a channel TCH of a thin film transistor TFT, a first electrode TS, and a second electrode TD. The channel TCH of the thin film transistor TFT may be a region that overlaps with the gate electrode TG of the thin film transistor TFT in the third direction DR3, which is the thickness direction of the substrate SUB. The first electrode TS of the thin film transistor TFT may be disposed on one side of the channel TCH, and the second electrode TD may be disposed on the other side of the channel TCH. The first electrode TS and the second electrode TD of the thin film transistor TFT may be regions that do not overlap with the gate electrode TG in the third direction DR3. The first electrode TS and the second electrode TD of the thin film transistor TFT may be regions in which a silicon semiconductor or an oxide semiconductor is doped with ions to make the regions conductive.

The gate insulation film 130 may be disposed on the active layer ACT. The gate insulation film 130 may be formed of an inorganic film, such as, for example, a silicon nitride layer, a silicon oxynitride layer, a silicon oxide layer, a titanium oxide layer, or an aluminum oxide layer.

The first gate layer GTL1 may be disposed on the gate insulation film 130. The first gate layer GTL1 may include a gate electrode TG of a thin film transistor TFT and a first capacitor electrode CAE1. The first gate layer GTL1 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A first interlayer insulation film 141 may be disposed on the first gate layer GTL1. The first interlayer insulation film 141 may be formed of an inorganic film, such as, for example, a silicon nitride layer, a silicon oxynitride layer, a silicon oxide layer, a titanium oxide layer, or an aluminum oxide layer.

The second gate layer GTL2 may be disposed on the first interlayer insulation film 141. The second gate layer GTL2 may include a second capacitor electrode CAE2. The second gate layer GTL2 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

The second interlayer insulation film 142 may be disposed on the second gate layer GTL2. The second interlayer insulation film 142 may be formed of an inorganic film, such as, for example, a silicon nitride layer, a silicon oxynitride layer, a silicon oxide layer, a titanium oxide layer, or an aluminum oxide layer.

The first data metal layer DTL1 including a first connection electrode CE1, a first sub-pad SPD1, and data line DL may be disposed on the second interlayer insulation film 142. The data line DL may be integrally formed with the first sub-pad SPD1, but the embodiments of the present disclosure are not limited thereto. The first data metal layer DTL1 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

The first connection electrode CE1 may be connected to the first electrode TS or the second electrode TD of a thin film transistor TFT through a first contact hole CT1 penetrating a first interlayer insulation film 141 and a second interlayer insulation film 142.

The first planarization film 160 may be disposed to flatten a step caused by the active layer ACT, the first gate layer GTL1, the second gate layer GTL2, and the first data metal layer DTL1 on the first data metal layer DTL1. The first planarization film 160 may be formed from an organic film such as, for example, an acrylic resin, an epoxy resin, a phenolic resin, a polyamide resin, a polyimide resin, or the like.

The second data metal layer DTL2 may be disposed on the first planarization film 160. The second data metal layer DTL2 may include a second connection electrode CE2 and a second sub-pad PD2. The second connection electrode CE2 may be connected to the first connection electrode CE1 through a second contact hole CT2 penetrating the first insulation film 161 and the first planarization film 160. The second data metal layer DTL2 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

The second planarization film 180 may be disposed on top of the second data metal layer DTL2. The second planarization film 180 may be formed of an organic film such as, for example, an acrylic resin, an epoxy resin, a phenolic resin, a polyamide resin, a polyimide resin, or the like.

The third data metal layer DTL3 may be disposed on the second planarization film 180. The third data metal layer DTL3 may include a third connection electrode CE3 and a third sub pad SPD3. The third connection electrode CE3 may be connected to the second connection electrode CE2 through a third contact hole CT3 penetrating the second insulation film 181 and the second planarization film 180. The third data metal layer DTL3 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

The third planarization film 190 may be disposed on top of the third data metal layer DTL3. The third planarization film 190 may be formed of an organic film, such as, for example, an acrylic resin, an epoxy resin, a phenolic resin, a polyamide resin, a polyimide resin, or the like.

The fourth data metal layer DTL4 may be disposed on the third planarization film 190. The fourth data metal layer DTL4 may include an anode pad electrode APD, a cathode pad electrode CPD, and a fourth sub pad SPD. The anode pad electrode APD may be connected to the third connection electrode CE3 through a fourth contact hole CT4 penetrating a third insulation film 191 and the third planarization film 190. The cathode pad electrode CPD may be supplied with a first power supply voltage that is a low potential voltage. The fourth data metal layer DTL4 may be formed as a single layer or multiple layers of any one of molybdenum (Mo), aluminum (Al), chromium (Cr), gold (Au), titanium (Ti), nickel (Ni), neodymium (Nd), and copper (Cu), or an alloy thereof.

A transparent conductive layer TCO may be disposed to increase adhesion with a first contact electrode CTE1 and a second contact electrode CTE2 of the light emitting element LE on each of the anode pad electrode APD and cathode pad electrode CPD. The transparent conductive layer (TCO) may be formed of a transparent conductive oxide such as, for example, indium tin oxide (ITO) and indium zinc oxide (IZO). In other embodiments, the transparent conductive layer (TCO) may be omitted.

A protective film PVX may be disposed on the anode pad electrode APD, cathode pad electrode CPD, and first pad PD1. The protective film PVX may be disposed such that the protective film PVX covers the edges of the anode pad electrode APD, the cathode pad electrode CPD, and the first pad PD1. The protective film PVX may be formed of an inorganic film, such as, for example, a silicon nitride layer, a silicon oxynitride layer, a silicon oxide layer, a titanium oxide layer, or an aluminum oxide layer. In other embodiments, the protective film PVX may be omitted.

The light emitting element LE is illustrated as a flip-chip type micro LED in which the first contact electrode CTE1 and the second contact electrode CTE2 are disposed opposite the anode pad electrode APD and the cathode pad electrode CPD. The light emitting element LE may be the inorganic light emitting element formed of an inorganic material such as, for example, GaN. The light emitting element LE may have a length in the first direction DR1, a length in the second direction DR2, and a length in the third direction DR3 of several to several hundred µm each. For example, the light emitting element LE may have the length in the first direction DR1, the length in the second direction DR2, and the length in the third direction DR3 of about 100 µm or less.

The light emitting elements LE may be formed by growth on a semiconductor substrate such as, for example, a silicon wafer. Each of the light emitting elements LE may be transferred directly from the silicon wafer onto the anode pad electrode APD and the cathode pad electrode CPD of the substrate SUB. In this case, the first contact electrode CTE1 and the anode pad electrode APD may be bonded together through a bonding process. In some aspects, the second contact electrode CTE2 and the cathode pad electrode CPD may be bonded to each other through the bonding process. The first contact electrode CTE1 and the anode pad electrode APD may be electrically connected to each other through a bonding electrode 23. Further, the second contact electrode CTE2 and the cathode pad electrode CPD may be electrically connected to each other through the bonding electrode 23.

In an embodiment, the bonding electrode 23 may be disposed on one side of the light emitting element LE. The bonding electrode 23 may be a bonding material of a pressurized melt bonding using a laser. Here, the pressurized melt bonding refers to a state in which the bonding electrode 23 is melted under heat to melt and mix the light emitting element LE, the anode pad electrode APD, and the cathode pad electrode CPD, and is cooled and solidified when the laser supply is terminated. The conductivity of the light emitting element LE and the anode pad electrode APD and the cathode pad electrode CPD is maintained while being cooled and solidified from the molten mixed state. Thus, the anode pad electrode APD and cathode pad electrode CPD and the light emitting element LE may be electrically connected and physically connected respectively. Therefore, the bonding electrode 23 may be disposed on the first contact electrode CTE1 and the second contact electrode CTE2 of the light emitting element LE.

The bonding electrode 23 may include, for example, Au, AuSn, PdIn, InSn, NiSn, Au-Au, Agln, AgSn, Al, Ag, or carbon nanotubes (CNT). Each of these may be utilized alone or in combination with two or more. Based on the type of bonding electrode 23, the bonding electrode 23 may be formed by deposition on the pad electrode or may be formed on the pad electrode by various methods such as, for example, screen printing.

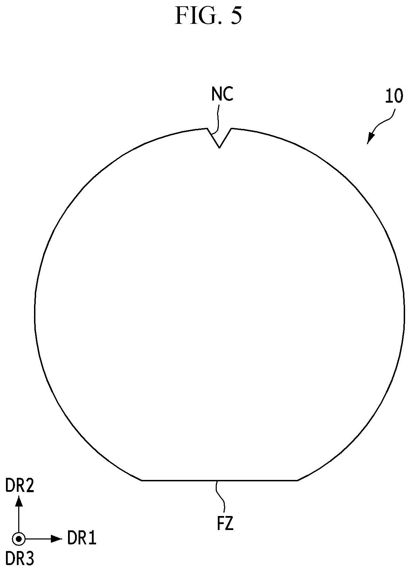

Alternatively, each of the light emitting elements LE may be transferred onto the anode pad electrode APD and the cathode pad electrode CPD of the substrate SUB using a transfer member. This will be described herein with reference to FIGS. 5 to 19.

Each of the light emitting elements LE may be a light emitting structure including a base substrate SPUB, an n-type semiconductor NSEM, an active layer MQW, a p-type semiconductor PSEM, a first contact electrode CTE1, and a second contact electrode CTE2.

The base substrate SPUB may be a sapphire substrate, but embodiments of the present disclosure are not limited thereto.

The n-type semiconductor NSEM may be disposed on one side of the base substrate SPUB. For example, the n-type semiconductor NSEM may be disposed on a bottom surface of the base substrate SPUB. The n-type semiconductor NSEM may include GaN doped with n-type conductive dopants such as, for example, Si, Ge, Sn, and the like.

The active layer MQW may be disposed on a portion of one side of an n-type semiconductor NSEM. The active layer MQW may include material with a single or multiple quantum well structure. If the MQW includes a material with a multi-quantum well structure, the active layer MQW may be a stacked structure with a plurality of well layers and barrier layers alternating with each other. In this case, the well layer may be formed of InGaN and the barrier layer may be formed of GaN or AlGaN, but is not limited thereto. Alternatively, the active layer MQW may be a structure in which a semiconductor material with a large band gap energy and a semiconductor material with a small band gap energy are alternately stacked on top of each other or may include three or five different semiconductor materials based on the wavelength of the light to be emitted.

In an embodiment, a flip-type light emitting element is illustrated in which the first contact electrode CTE1 and the second contact electrode CTE2 are disposed on one side of the light emitting element LE, but is not limited thereto, and may be a vertical light emitting element in which the first contact electrode CTE1 and the second contact electrode CTE2 are disposed on both ends of the light emitting element LE.

FIG. 5 is a plan view illustrating a wafer.

Referring to FIG. 5, the wafer 10 may be a semiconductor substrate suitable for epitaxial growth of a semiconductor. For example, the wafer substrate may be a substrate including a material such as, for example, silicon (Si), sapphire, SiC, GaN, GaAs, or ZnO. If the wafer may smoothly perform epitaxial growth for manufacturing a light emitting element (LE in FIG. 4), the type, material, and shape of the wafer substrate WAF are not particularly limited.

The wafer 10 may include at least one of a flat zone FZ or a notch NC indicating the crystal orientation of the wafer.

The flat zone FZ is a region where the crystal plane of the wafer is made flat. The notch NC is a triangular groove indicating the crystal orientation of the wafer. In another variation, an alignment marker may be used instead of the flat zone FZ or the notch NC.

In an embodiment, the wafer 10 may have a diameter of about 8 inches, 10 inches or 12 inches.

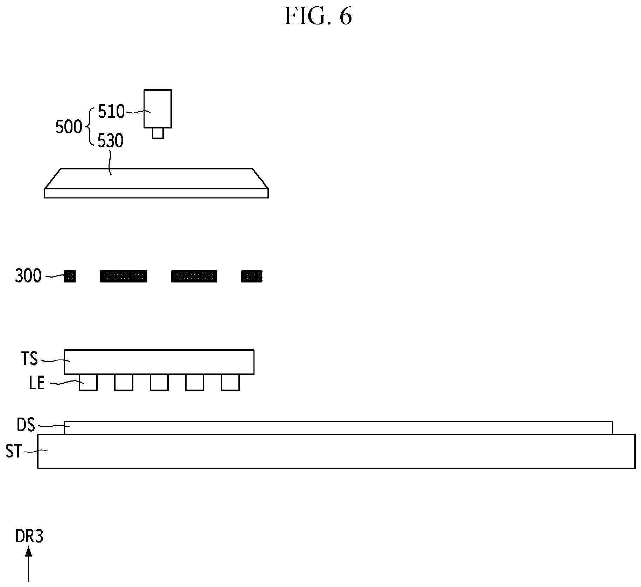

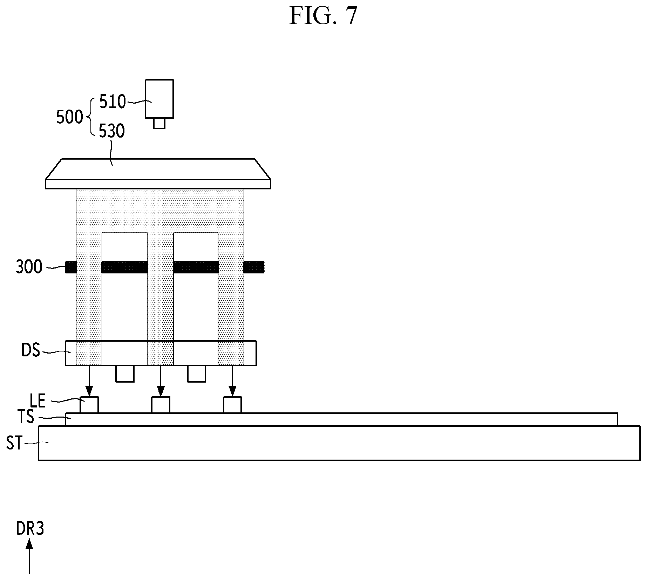

FIG. 6 is a schematic diagram schematically illustrating a light emitting element transfer device. FIG. 7 is a drawing to illustrate the operation of a light emitting element transfer device.

Referring to FIG. 6, a light emitting element transfer device (hereinafter, referred to as a transfer device) may be used to transfer a light emitting element LE on a donor substrate DS to a target substrate TS.

The donor substrate DS may be a wafer on which the light emitting element LE has grown but is not limited thereto. The target substrate TS may be a relay substrate but is not limited thereto. The target substrate TS may also be a circuit board.

The transfer device may include a support member ST, a mask member 300, a laser emitting member 500 (also referred to herein as a laser irradiation member), and a controller (not shown).

The support member ST may have an upper surface parallel to a plane defined by a first direction DR1 and a second direction DR2 that are perpendicular to each other, and a target substrate TS on which a plurality of light emitting elements LE are disposed may be placed on the upper surface.

The support member ST may be a loading plate and may be formed in a polygonal flat plate shape such as, for example, a square, rectangle, or the like. Alternatively, the support member ST may be formed in a circular, oval, or other planar plate shape. In an embodiment, the support member ST may fix the target substrate TS.

The laser emitting member 500 is disposed opposite the front side of the donor substrate DS and may emit laser light toward the donor substrate DS, irradiating the donor substrate DS with the laser light. The laser emitting member 500 may be disposed on the uppermost surface of the manufacturing device. The laser emitting member 500 may emit laser light toward the support member ST disposed on the lowermost surface of the manufacturing device, and the light emitted from the laser emitting member 500 may irradiate (and be incident) a plurality of light emitting elements LE disposed on the donor substrate DS.

The laser emitting member 500 may include a laser light source 510 and an optical system 530.

The laser light source 510 is a device that may generate laser light by energy supplied from the outside, and may be configured to generate laser light such as, for example, a solid-state laser such as, for example, a YAG laser, a ruby laser, a glass laser, a YVO4 laser, an LD laser, a fiber laser, a liquid laser such as, for example, a pigment laser, a CO₂ laser, an excimer laser (ArF laser, KrF laser, XeCl laser, XeF laser, or the like), a gaseous laser such as, for example, an Ar laser, a He-Ne laser, a semiconductor laser, a free-electron laser, or the like.

The optical system 530 may include a plurality of lenses. The optical system 530 may receive beam-shaped laser light from the laser light source 510 and perform optical dispersion to enable area heating for a predetermined area.

The laser light emitted from the optical system 530 irradiates the light emitting elements LE disposed on the donor substrate DS mounted on the support member ST and may heat a predetermined area of the light emitting elements LE.

A mask member 300 is disposed between the support member ST and the laser emitting member 500.

The mask member 300 may include a mask including a base layer and a light blocking pattern layer. The base layer is formed in a transparent or translucent flat plate shape including at least one transparent material such as, for example, glass, quartz, silicon, or the like. The base layer has light-transmitting properties supportive of transmitting laser light in the opposite direction, that is, the front or back. The light blocking pattern layer is disposed on one surface of the base layer and may have light blocking properties or reflectivity and may include an opening pattern. The opening pattern is a region that does not have light blocking properties or reflectivity and transmits light. The light blocking pattern layer may be formed by patterning a material having light blocking properties using a method such as, for example, a photo process. The light blocking material may include, for example, chromium (Cr), chromium oxynitride (CrON), chromium nitride (CrN), molybdenum silicide oxide (MoSiO), molybdenum silicide oxynitride (MoSiON), tantalum oxide (TaO), tantalum silicide oxide (TaSiO), and the like. The light blocking pattern layer includes a light blocking material in a region other than the opening pattern.

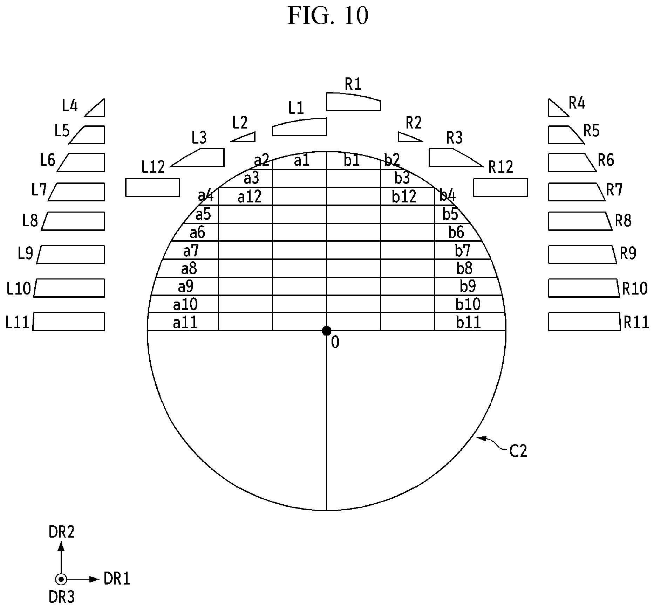

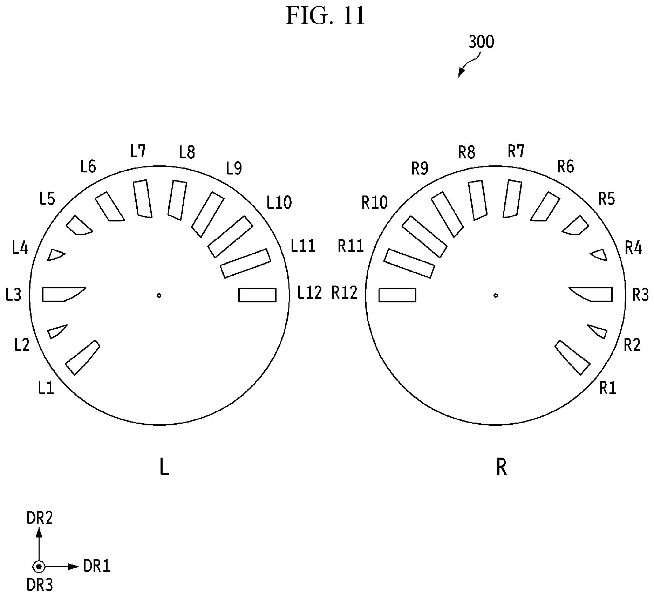

The opening pattern includes a plurality of openings. As illustrated in FIG. 7, a laser beam transmitted by the laser emitting member 500 may pass through the openings of the mask member 300 but be blocked by the remainder of the mask member 300. Therefore, the openings may define a transmission area for the laser beam. Here, the light emitted from the laser emitting member 500 transmits through one opening among the plurality of openings of the opening pattern and irradiates (is incident) the plurality of light emitting elements LE disposed on the target substrate TS. The mask member 300 will be described in detail with reference to FIGS. 10 and 11.

The mask member 300 may include a driving member such as, for example, a motor and a rotating bearing that rotates the masks. The mask member 300 may rotate the masks according to the instructions of the controller.

The controller is connected to the laser emitting member 500 and the mask member 300 and is configured to perform processing supportive of transferring a light emitting element LE by controlling the operation of the laser emitting member 500 and the mask member 300 by the controller. The controller is provided with an interface (not illustrated) that transmits and receives signals between the above-described components, such as, for example, the laser emitting member 500 and the mask member 300, for example. The controller is configured to perform processing for transferring the light emitting element based on the detection result of a camera, a sensor, or the like. For example, the controller recognizes a position of the transfer target area based on an image captured by the camera, aligns the masks of the mask member 300 such as, for example, by rotating and positioning the masks based on the detection result, and performs control related to the operation of the transferring machine emitting the laser and irradiating the transfer target area with the laser.

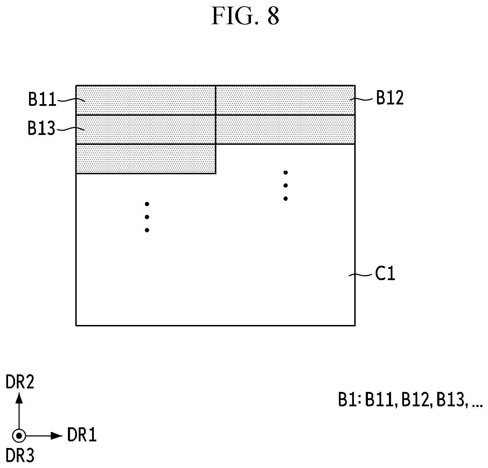

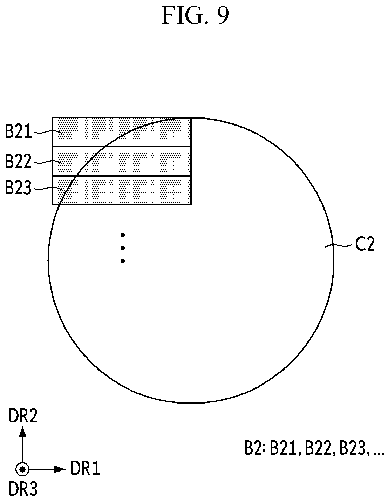

FIG. 8 is a plan view illustrating a square-shaped cell and a square opening pattern. FIG. 9 is a plan view illustrating a circular cell and a square opening pattern.

The target substrate (TS in FIG. 6) may have a size corresponding to the area of a plurality of cells or a region corresponding to the cells for forming a plurality of display panels (100 in FIG. 1). In the display device manufacturing process after the transfer process, the target substrate TS may be divided into regions each including one cell.

Here, the cell may be a region in the target substrate TS to which the light emitting element LE is to be transferred.

Referring to FIG. 8, a transfer region B1 formed using a square opening pattern in a square-shaped cell C1 is illustrated. For example, a first transfer region B11 of the cell C1 is implemented using a square opening pattern. Thereafter, the opening pattern is moved to an area where transfer is not performed (e.g. has not been performed) to implement a second transfer region B12. Then, the pattern is moved to an area where transfer is not performed to implement a third transfer region B13. In this way, a transfer region B1 may be implemented in the entire area of the cell C1. In this way, transfer may be performed appropriately for the entire area of a square cell C1 using a square opening pattern. A transfer region may, in one example, be referred to as a laser transfer area.

Referring to FIG. 9, a transfer region B2 formed using a square opening pattern in a circular cell C2 is illustrated. For example, a first transfer region B21 of a cell C2 is implemented using a square opening pattern. Then, the second transfer region B22 is implemented by moving the opening pattern to an area where transfer is not performed. Thereafter, a third transfer region B23 is implemented by moving the pattern to an area where transfer is not performed. In this way, a transfer region B2 may be implemented for the entire area of the cell C2. In this way, when transfer is performed for the entire circular cell C2 using a square opening pattern, a transfer region is formed outside the edge of the circular cell C2, so there is a problem that the light emitting element may be transferred to an area outside the cell.

FIG. 10 is a plan view illustrating examples of various opening patterns corresponding to a circular cell C2 of the present disclosure.

The circular shape C2 is symmetrical from top to bottom and from left to right with respect to the center O of the cell. For convenience of explanation, when dividing the center of the cell into four quadrants from top to bottom, left to right, and top to bottom, the upper right is referred to as the 1^{st} quadrant, the upper left is referred to as the 2^{nd} quadrant, the lower left is referred to as the 3^{rd} quadrant, and the lower right is referred to as the 4^{th} quadrant. The first quadrant is divided by a plurality of lines parallel to the axis in the second direction DR2 and a plurality of lines parallel to the axis in the first direction DR1, and each of the divisions of different shapes is labeled. For example, the eleven different shaped regions divided by angle along the circumference of the circle in a clockwise direction may be labeled as b1 to b11, and an identically sized square region located at the center of the first quadrant may be labeled as b12. In an example in which the same opening pattern as the region labeled b1 to b12 is prepared, a transfer region completely corresponding to the entire region of the first quadrant may be implemented with 12 opening patterns. In other words, a transfer region for a circular cell C2 may be implemented with the opening patterns of b1 to b12, and the shape and size of the transfer region may prevent the light emitting element from being transferred to outside of the first quadrant of the circular cell C2.

Similarly, the second quadrant is divided by a plurality of lines parallel to the axis of the second direction DR2 and a plurality of lines parallel to the axis of the first direction DR1, and each of the regions having different shapes is labeled. For example, the 11 regions of different shapes divided by angle along the circumference of the circle in the counterclockwise direction may be labeled as a1 to a11, and a region of a square of the same size located at the center of the second quadrant may be labeled as a12. In an example in which the same opening pattern as the area labeled a1 to a12 is prepared, a transfer area completely corresponding to the entire area of the second quadrant may be implemented with 12 opening patterns. That is, a transfer region for the circular cell C2 may be implemented with the opening patterns of a1 to a12, and the shape and size of the transfer region may prevent the light emitting element from being transferred outside the second quadrant of the circular cell C2.

The compartment lines of each of the first and second quadrants may be symmetrical to each other. Accordingly, the opening patterns of each of the first and second quadrants may also be symmetrical to each other. For example, the a1 opening pattern of the second quadrant and the b1 opening pattern of the first quadrant are symmetrical to each other, and the a2 opening pattern of the second quadrant and the b2 opening pattern of the first quadrant are symmetrical to each other. In this way, the opening pattern of the first quadrant and the opening pattern of the same number of the second quadrant are symmetrical to each other.

In some embodiments, a transfer area that completely corresponds to the entire area of the third quadrant may be implemented by rotating and using the 12 opening patterns b1 to b12 of the first quadrant. In some aspects, a transfer area that completely corresponds to the entire area of the fourth quadrant may be implemented by rotating and using the 12 opening patterns a1 to a12 of the fourth quadrant.

In other words, a transfer area that completely corresponds to the entire area of the circular cell C2 may be implemented with the opening patterns a1 to a12 and b1 to b12.

FIG. 11 is a plan view to illustrate a mask member according to an embodiment.

The mask member of FIG. 11 corresponds to the mask member of FIG. 6.

Referring to FIG. 11, the circular mask member includes a pair of first masks L and second masks R.

The first mask L includes opening patterns of different shapes. Each opening pattern may be a polygon having a square shape or a curved shape. For example, each opening pattern may be a polygon having straight edges, curved edges, or a combination of one or more straight edges and one or more curved edges. In an example, each opening pattern of the first mask L may correspond to an opening pattern of a1 to a12 in a circular cell (cell C2 in FIG. 10). The first mask L has opening patterns disposed at angles relative to the center point of the mask.

The second mask R includes opening patterns of different shapes. Each of the opening patterns may be a polygon having a square shape or a curved shape. For example, each opening pattern of the second mask R may correspond to an opening pattern of b1 to b12 in a circular cell (cell C2 in FIG. 10). The second mask R has opening patterns disposed at angles relative to the center point of the mask.

The first mask L and the second mask R may have the same diameter.

The first mask L and the second mask R may form tens to hundreds of opening patterns at angles relative to the center.

The smaller the radius of the first mask L and the second mask R, the more vibration or motor load due to the rotation speed may be minimized, such that stable operation is possible.

The opening patterns of the first mask L and the second mask R have shapes that are symmetrical to each other on both sides.

Embodiments of the present disclosure include overlapping the opening pattern of the first mask L and the opening pattern of the second mask R in association with defining the transfer area. The mask member 300 may rotate the first mask L and the second mask R such that the opening pattern of the first mask L and the opening pattern of the second mask R overlap in a straight line, and the overlap may define the transfer area.

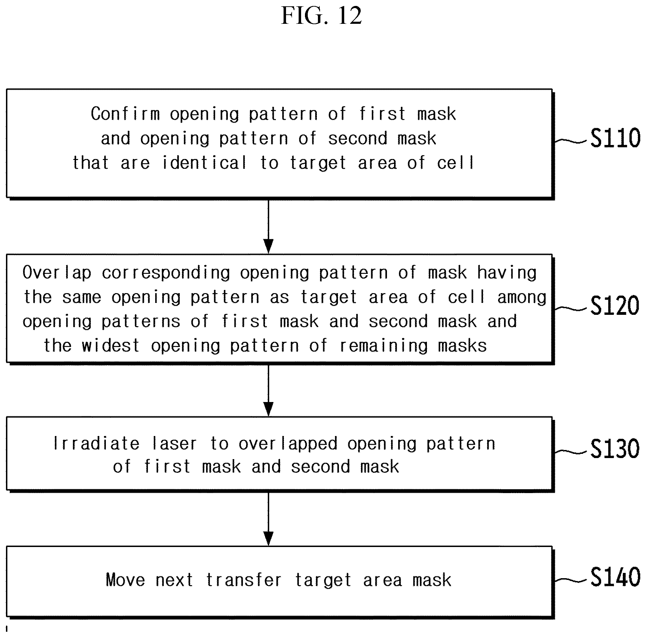

FIG. 12 is a flow chart to illustrate a transfer method of a light emitting element according to an embodiment.

Hereinafter, a method for transferring a light emitting element by a light emitting element transfer device of FIG. 6 will be described with reference to FIGS. 10 to 12. In the descriptions of the method and processes herein, the operations may be performed in a different order than the order shown and/or described, or the operations may be performed in different orders or at different times. Certain operations may also be left out of the flowcharts, one or more operations may be repeated, or other operations may be added. Descriptions that an element "may be disposed," "may be formed," "may be emitted," and the like include methods, processes, and techniques for performing the same in accordance with example aspects described herein.

First, the method may include checking, by a controller (e.g. that described with reference to FIG. 6), the shapes of the opening patterns of the first mask L and the second mask R in association with finding an opening pattern having the same shape as the transfer target area of the cell. (S110). For example, at S110, the method may include determining, from among the opening patterns of the first mask L and the opening patterns of the second mask R, an opening pattern that is identical to a transfer target area of the cell.

Second, the method may include controlling, by the controller, the mask member 300 to create an overlap between a corresponding opening pattern of a mask (e.g., first mask L) having the same shape as the transfer target area among the opening patterns of the first mask L and the second mask R with the widest opening pattern of the remaining mask (e.g., second mask R). (S120). For example, the method may include rotating, by the controller, at least one of the first mask L and the second mask R such that an opening pattern of the first mask L overlaps a widest opening pattern among the opening patterns of the second mask R, wherein the shape of the opening pattern of the first mask L is identical to the shape of the transfer target area. In an alternative example, the method may include rotating, by the controller, at least one of the first mask L and the second mask R such that an opening pattern of the second mask R overlaps a widest opening pattern among the opening patterns of the first mask L, wherein the shape of the opening pattern of the second mask R is identical to the shape of the transfer target area.

The first mask L and the second mask R may each be capable of rotating at high speed.

Third, the method may include emitting a laser and irradiating, with the laser, the overlapped opening patterns of the first mask L and the second mask R. (S130).

The method may include emitting the laser and irradiating the overlapped opening patterns of the first mask L and the second mask R while rotating the first mask L and the second mask R. For example, the method may include irradiating the opening pattern formed by the overlap between the opening pattern of the first mask L and the widest opening pattern of the second mask R with the laser at a temporal instance when the opening pattern of the first mask L and the widest opening pattern of the second mask R overlap and are disposed in a straight line. For example, if a pattern formed by the overlapping opening patterns of the first mask L and the second mask R is identical to the desired opening pattern, the method may include emitting and/or directing the laser such that the overlapping opening patterns are irradiated at a temporal instance when the opening patterns overlap and are disposed on a straight line, thereby irradiating the overlapping opening patterns with the laser without reducing the rotation speed or stopping the rotation of the first mask L and the second mask R.

Fourth, the method may include moving the mask member 300 to a next transfer target area. (S140). For example, the method may include moving, by providing control signals from the controller to a stage (not illustrated) on which the mask is disposed or to which the mask is fixed. In an example, the stage may move based on the control signals.

The method may include transferring light emitting elements to all cell areas by repeating steps S110 to S140 until there is no next transfer target area.

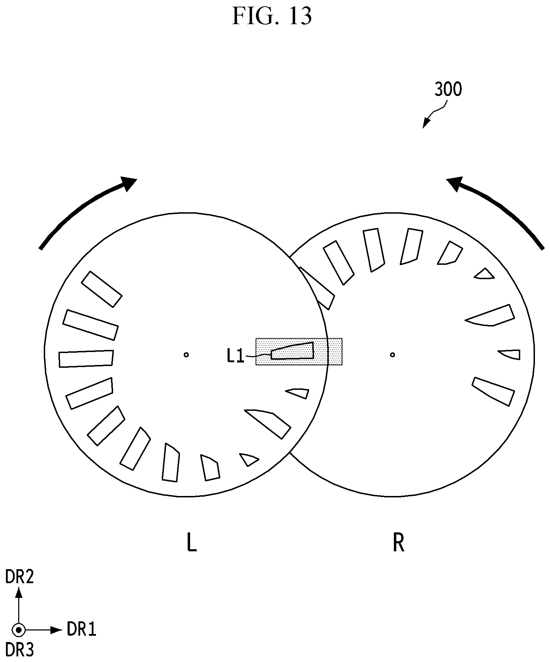

FIGS. 13 to 15 are example drawings to illustrate a transfer method using the mask member of FIG. 12.

Referring to FIG. 13, a method for setting a transfer region corresponding to the a1 region of FIG. 10 is described.

The method may include disposing the first mask L and the second mask R such that a part of the first mask L and a part of the second mask R overlap.

The method may include selecting the a1 region of FIG. 10 as a transfer target area.

The method may include finding an opening pattern having the same shape as the a1 region of the transfer target. Among the opening pattern of the first mask L and the opening pattern of the second mask R, an opening pattern having the same shape as the a1 region of the transfer target is found. Since the opening pattern L1 of the first mask L corresponds to the a1 region, the method may include rotating the first mask L and the second mask R respectively such that the opening pattern L1 of the first mask L and the opening pattern R11 of the second mask R overlap.

The method may include emitting a laser such that the laser irradiates the area where the opening pattern L1 and the opening pattern R11 overlap. Accordingly, the laser light passes through the opening pattern L1, which is a smaller opening among the opening pattern L1 and the opening pattern R11, and irradiates a transfer area corresponding to the a1 region.

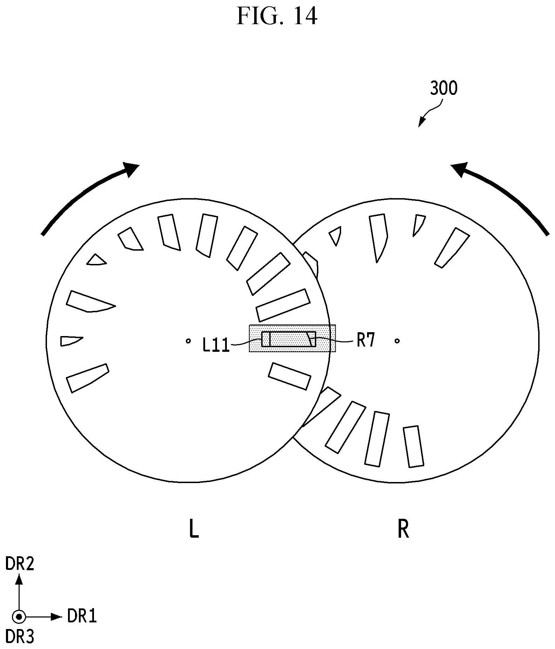

Referring to FIG. 14, a method for setting a transfer area corresponding to the b7 region of FIG. 10 is described.

The method may include disposing the first mask L and the second mask R such that the first mask L and the second mask partially overlap each other.

The method may include finding an opening pattern having the same shape as the b7 region. Among the opening pattern of the first mask L and the opening pattern of the second mask R, an opening pattern having the same shape as the b7 region is found. Since the opening pattern R7 of the second mask R corresponds to the b7 region, the method may include rotating each of the first mask L and the second mask R such that the opening pattern L11 of the first mask L and the opening pattern R7 of the second mask R overlap each other.

The method may include emitting a laser such that the laser irradiates the area where the opening pattern L11 and the opening pattern R7 overlap. Accordingly, the laser light passes only through the opening pattern R7, which is a smaller opening among the opening pattern L11 and the opening pattern R7, thereby irradiating a transfer area corresponding to the b7 region.

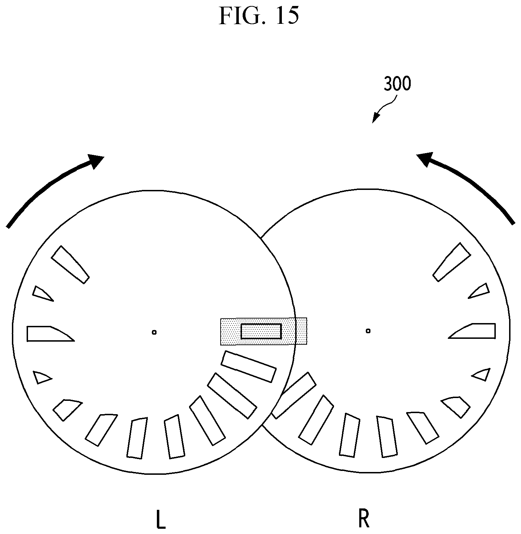

Referring to FIG. 15, a method for setting a transfer area corresponding to the a12 region of FIG. 10 is described.

The method may include disposing the first mask L and the second mask R such that a part of the first mask L and a part of the second mask R overlap.

The method may include finding an opening pattern having the same shape as the a12 region among the opening pattern of the first mask L and the opening pattern of the second mask R. Since the opening pattern L12 of the first mask L and the opening pattern R12 of the second mask R both correspond to the a12 region, the method may include rotating the first mask L and the second mask R respectively such that the opening pattern L12 of the first mask L and the opening pattern R12 of the second mask R overlap.

The method may include emitting the laser such that the laser irradiates the area where the opening pattern L11 and the opening pattern R7 overlap. Accordingly, the laser light passes only through the opening pattern R7, which is a smaller opening among the opening pattern L11 and the opening pattern R7, and irradiates a transfer area corresponding to the opening pattern b7 region.

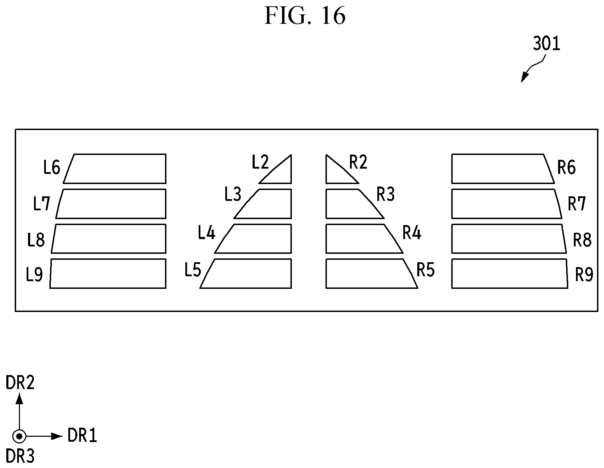

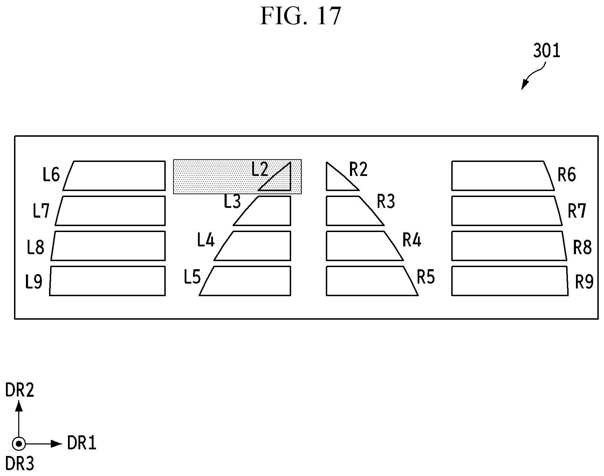

FIG. 16 is a plan view to illustrate a mask member according to another embodiment. FIG. 17 is an example drawing to illustrate a transfer method using the mask member of FIG. 16.

The mask member 301 of FIG. 16 differs from the mask member 300 of FIG. 11 in that the mask member 301 is a singular structure (i.e., is not formed in pairs) and has a square shape rather than a circle.

Embodiments of the present disclosure are described herein with reference to FIG. 10 and FIG. 16.

The mask member 301 includes opening patterns L2, L3... L9 and opening patterns R2, R3... R9 of different shapes. Each of the opening patterns L2, L3... L9 and opening patterns R2, R3...R9 may be a square or a polygon including a curved surface. In an example embodiment, 16 opening patterns are provided in one mask member 301 but embodiments of the present disclosure are not limited thereto.

For example, the opening patterns of the mask member 301 may respectively correspond to the opening patterns of a1 to a12 in a circular cell (cell C2 in FIG. 10). The circular cell shape may be transferred by combining each opening pattern. Each opening pattern may be disposed in a matrix.

The method may include finding, from among the opening patterns of the mask member 301, an opening pattern matching the transfer target area and superimposing the opening pattern on the transfer target area.

Referring to FIG. 17, a method for setting a transfer area corresponding to the a2 region of FIG. 10 is described.

The method may include selecting the a2 region of FIG. 10 as the transfer target area.

The method may include finding, from among the opening patterns in the mask member 301, an opening pattern having the same shape as the a2 region. The method may include superimposing the opening pattern on the transfer target area, and emitting a laser such that the laser irradiates the opening pattern.

The method may include moving the mask member 301 to a next transfer target area, and performing transferring (i.e., transferring a light emitting element) on the next transfer target area.

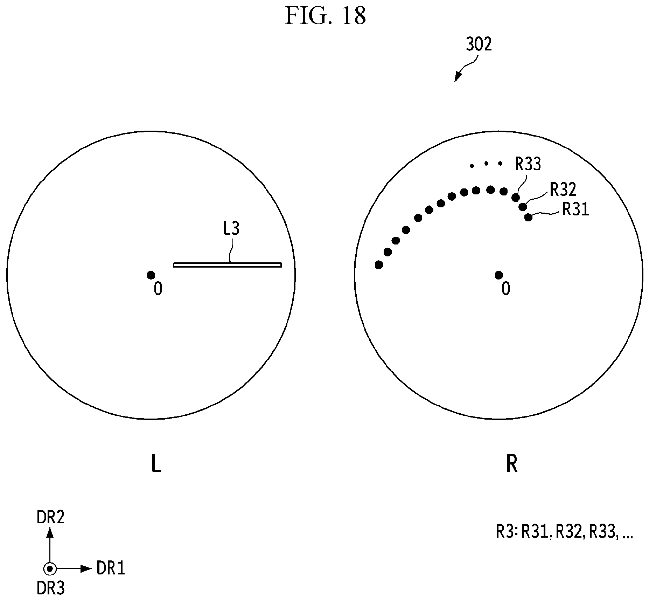

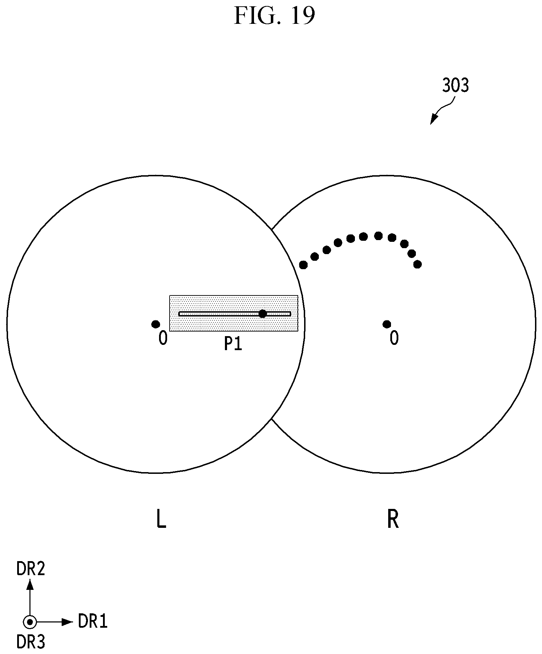

FIG. 18 is a plan view to illustrate a mask member according to another embodiment. FIG. 19 is an example drawing to illustrate a transfer method using the mask member of FIG. 18.

The mask member 302 of FIG. 18 is different from the mask member 300 of FIG. 11 in that, for the mask member 302, the opening patterns of the first mask L and the second mask R are not symmetrical to each other.

Embodiments of the present disclosure are described with reference to FIG. 10 and FIG. 18.

The mask member 302 includes a first mask L including an opening pattern L3 in a single row shape and a second mask R including an opening pattern R3 which includes opening patterns R31, R32, R33 ... , and each of the opening pattern R31, R32, R33 ... may have a size and shape corresponding to a single light emitting element.

Each opening pattern R31, R32, R33... of the second mask R has the same size and shape corresponding to a single light emitting element, but the respective distances of the opening patterns R31, R32, R33... from the center of the second mask R may be different from one another. In the example of FIG. 18, the opening patterns R31, R32, R33... are circular, but are not limited thereto, and may be rectangular or square based on the planar shape of the light emitting element to be transferred. The respective diameters of the opening patterns R31, R32, R33... may be the same as the diameters of the light emitting elements to be transferred.

The first opening pattern R31 may be disposed closer to the center of the circle than the second opening pattern R32. The second opening pattern R32 may be disposed closer to the center of the circle than the third opening pattern R33. Similarly, as the number of opening patterns increases, each additional opening pattern (e.g., a fourth opening pattern (not illustrated), a fifth opening pattern (not illustrated), and the like) may respectively be disposed further from the center of the circle.

Referring to FIG. 19, the method may include disposing the first mask L and the second mask R such that a part of the first mask L and a part of the second mask R overlap.

The method may include rotating each of the first mask L and the second mask R such that the opening pattern L3 of the first mask L and the opening pattern R3 of the second mask R overlap. The method may include emitting a laser such that the laser irradiates the area where the opening pattern L3 and the opening pattern R3 overlap. As a result, of irradiating the area, a single light emitting element may be transferred to a desired transfer location.

Embodiments are set out in the following clauses:
Clause 1. A mask member comprising: a first mask comprising a light blocking pattern layer and a base layer, wherein the light blocking pattern layer of the first mask comprises a plurality of opening patterns; and a second mask comprising a light blocking pattern layer and a base layer, wherein the light blocking pattern layer of the second mask comprises a plurality of opening patterns disposed at angles relative to a center of the second mask, wherein the mask member defines a transfer area by overlapping an opening pattern of the plurality of opening patterns of the first mask and an opening pattern of the plurality of opening patterns of the second mask.
Clause 2. The mask member of Clause 1, wherein: the plurality of opening patterns of the first mask are disposed at angles relative to a center of the first mask, and the plurality of opening patterns of the first mask and the plurality of opening patterns of the second mask are left-right symmetrical.
Clause 3. The mask member of Clause 1 or 2, wherein respective shapes of the opening patterns of the second mask are different from one another.
Clause 4. The mask member of any preceding clause, wherein the opening pattern of the second mask is a polygon having a square shape or a curved shape.
Clause 5. The mask member of any preceding clause, wherein: the base layer has a flat plate shape formed of a transparent material and has light-transmitting properties, the light blocking pattern layer of the first mask comprises a material having light-blocking properties in a region of the first mask different from the plurality of opening patterns, and the light blocking pattern layer of the second mask comprises the material having light-blocking properties in a region of the second mask different from the plurality of opening patterns.
Clause 6. The mask member of any preceding clause, wherein the first mask and the second mask are each rotatably disposed mask members.
Clause 7. The mask member of any preceding clause, wherein: the opening pattern of the plurality of opening patterns of the first mask has a single row shape, and each of the plurality of opening patterns of the second mask has a size and shape corresponding to a single chip.
Clause 8. A transfer device for transferring a light emitting element, the transfer device comprising: a laser emitting member; a support member disposed under the laser emitting member and supporting a target substrate; and a mask member disposed between a donor substrate disposed on the target substrate and the laser emitting member and defining a laser transfer area, wherein the mask member comprises: a first mask comprising a light blocking pattern layer and a base layer, wherein the light blocking pattern layer of the first mask comprises a plurality of opening patterns; and a second mask comprising a light blocking pattern layer and a base layer, wherein the light blocking pattern layer of the second mask comprises a plurality of opening patterns disposed at angles relative to a center of the second mask, wherein the transfer device defines the laser transfer area by overlapping an opening pattern of the plurality of opening patterns of the first mask and an opening pattern of the plurality of opening patterns of the second mask.
Clause 9. The transfer device of Clause 8, wherein: the plurality of opening patterns of the first mask are disposed at angles relative to a center of the first mask, and the plurality of opening patterns of the first mask and the plurality of opening patterns of the second mask are left-right symmetrical.
Clause 10. The transfer device of Clause 8 or 9, wherein respective shapes of the opening patterns of the second mask are different from one another.
Clause 11. The transfer device of any of Clauses 8 to 10, wherein the opening pattern of the second mask is a polygon having a square shape or a curved shape.
Clause 12. The transfer device of any of Clauses 8 to 11, wherein: the base layer has a flat plate shape formed of a transparent material and has light-transmitting properties, the light blocking pattern layer of the first mask comprises a material having light-blocking properties in a region of the first mask different from the plurality of opening patterns, and the light blocking pattern layer of the second mask comprises the material having light-blocking properties in a region of the second mask different from the plurality of opening patterns.
Clause 13. The transfer device of any of Clauses 8 to 12, wherein the first mask and the second mask are each rotatably disposed mask members.
Clause 14. The transfer device of any of Clauses 8 to 13, wherein: the target substrate comprises a plurality of cell areas for forming a plurality of display panels, and the plurality of cell areas are circular.
Clause 15. The transfer device of any of Clauses 8 to 14, wherein: the opening pattern of the plurality of opening patterns of the first mask has a single row shape, and each of the plurality of opening patterns of the second mask has a size and shape corresponding to a single chip.
Clause 16. A method of transferring a light emitting element comprising: checking, by a controller, shapes of opening patterns of a first mask and shapes of opening patterns of a second mask in association with finding an opening pattern having a shape identical to a shape of a transfer target area of a target substrate; rotating, by the controller, at least one of the first mask and the second mask such that an opening pattern of the first mask overlaps a widest opening pattern among the opening patterns of the second mask, wherein the shape of the opening pattern of the first mask is identical to the shape of the transfer target area; and irradiating, by emitting a laser, the opening pattern of the first mask and the widest opening pattern of the second mask which are overlapping.
Clause 17. The method of Clause 16, further comprising moving, by the controller, a mask member comprising the first mask and the second mask to a next transfer target area.
Clause 18. The method of Clause 16 or 17, wherein the opening pattern is irradiated with the laser at a temporal instance when the opening pattern of the first mask and the widest opening pattern of the second mask overlap and are disposed in a straight line.
Clause 19. The method of any of Clauses 16 to 18, wherein: the opening patterns of the first mask are disposed at angles relative to a center of the first mask and the opening patterns of the second mask are disposed at angles relative to a center of the second mask, and the opening patterns of the first mask and the opening patterns of the second mask are left-right symmetrical.
Clause 20. The method of any of Clauses 16 to 19, wherein: respective shapes of the opening patterns of the second mask are different from one another, and the opening pattern of the second mask is a polygon having a square shape or a curved shape.

In concluding the detailed description, those skilled in the art will appreciate that many variations and modifications can be made to the embodiments without substantially departing from the principles of the disclosure. Therefore, the disclosed embodiments of the disclosure are used in a generic and descriptive sense and not for purposes of limitation.

## Claims

1. A mask member (300) comprising:
a first mask (L) comprising a light blocking pattern layer and a base layer, wherein the light blocking pattern layer of the first mask (L) comprises a plurality of opening patterns (L1-L12); and
a second mask (R) comprising a light blocking pattern layer and a base layer, wherein the light blocking pattern layer of the second mask (R) comprises a plurality of opening patterns (R1-R12) disposed at angles relative to a center of the second mask (R),
wherein the mask member (300) defines a transfer area by overlapping an opening pattern of the plurality of opening patterns (L1-L12) of the first mask (L) and an opening pattern of the plurality of opening patterns (R1-R12) of the second mask (R).

2. The mask member of claim 1, wherein:
the plurality of opening patterns (L1-L12) of the first mask (L1) are disposed at angles relative to a center of the first mask (L1), and
the plurality of opening patterns (L1-L12) of the first mask (L1) and the plurality of opening patterns (R1-R12) of the second mask (R2) are left-right symmetrical.

3. The mask member of claim 1 or 2, wherein respective shapes of the opening patterns (R1-R12) of the second mask (R1) are different from one another.

4. The mask member of claim 3, wherein an opening pattern of the plurality of opening patterns (R1-R12) of the second mask (R2) is a polygon having a square shape or a curved shape.

5. The mask member of any preceding claim, wherein:
the base layer has a flat plate shape formed of a transparent material and has light-transmitting properties,
the light blocking pattern layer of the first mask (L1) comprises a material having light-blocking properties in a region of the first mask (L1) different from the plurality of opening patterns (L1-L12), and
the light blocking pattern layer of the second mask (R2) comprises the material having light-blocking properties in a region of the second mask (R2) different from the plurality of opening patterns (R1-R12).

6. The mask member of any preceding claim, wherein the first mask (L1) and the second mask (L2) are each rotatably disposed mask members (300).

7. The mask member of any preceding claim, wherein:
the opening pattern of the plurality of opening patterns (L3) of the first mask (L1) has a single row shape, and
each of the plurality of opening patterns (R31-R33) of the second mask (R2) has a size and shape corresponding to a single chip (LE).

8. A transfer device for transferring a light emitting element (LE), the transfer device comprising:
a laser emitting member (500);
a support member (ST) disposed under the laser emitting member (500) and supporting a target substrate (TS); and
the mask member (300) of any preceding claim, disposed between a donor substrate (DS) disposed on the target substrate (TS) and the laser emitting member (500) and defining a laser transfer area,
wherein the transfer device defines the laser transfer area by overlapping an opening pattern of the plurality of opening patterns (L1-L12) of the first mask (L1) and an opening pattern of the plurality of opening patterns (R1-R12) of the second mask (R1).

9. The transfer device of claim 8, wherein:
the plurality of opening patterns (L1-L12) of the first mask (L) are disposed at angles relative to a center of the first mask (L), and
the plurality of opening patterns (L1-L12) of the first mask (L) and the plurality of opening patterns (R1-R12) of the second mask (R2) are left-right symmetrical;
and/or wherein respective shapes of the opening patterns (R1-R12) of the second mask (R) are different from one another, wherein optionally an opening pattern of the plurality of opening patterns (R1-R12) of the second mask (R) is a polygon having a square shape or a curved shape;
and/or wherein the base layer has a flat plate shape formed of a transparent material and has light-transmitting properties, the light blocking pattern layer of the first mask (L) comprises a material having light-blocking properties in a region of the first mask (L) different from the plurality of opening patterns (L1-L12), and the light blocking pattern layer of the second mask (R) comprises the material having light-blocking properties in a region of the second mask (R) different from the plurality of opening patterns (R1-R12);
and/or wherein the first mask (L) and the second mask (R) are each rotatably disposed mask members (300)
and/or the opening pattern (L3) of the plurality of opening patterns of the first mask (L) has a single row shape, and
each of the plurality of opening patterns (R31-R33) of the second mask (R) has a size and shape corresponding to a single chip.

10. The transfer device of claim 8 or 9, wherein:
the target substrate (TS) comprises a plurality of cell areas for forming a plurality of display panels (100), and
the plurality of cell areas are circular.

11. A method of transferring a light emitting element (LE) comprising:
checking, by a controller, shapes of opening patterns (L1-L12) of a first mask (L) and shapes of opening patterns (R1-R12) of a second mask (R) in association with finding an opening pattern having a shape identical to a shape of a transfer target area of a target substrate (TS);
rotating, by the controller, at least one of the first mask (L) and the second mask (R) such that an opening pattern of the first mask (L) overlaps a widest opening pattern among the opening patterns (R1-R12) of the second mask (R), wherein the shape of the opening pattern of the first mask (L) is identical to the shape of the transfer target area; and
irradiating, by emitting a laser (500), the opening pattern of the first mask (L) and the widest opening pattern of the second mask (R) which are overlapping.

12. The method of claim 11, further comprising moving, by the controller, a mask member (300) comprising the first mask (L) and the second mask (R) to a next transfer target area.

13. The method of claim 12, wherein the opening pattern is irradiated with the laser (500) at a temporal instance when the opening pattern of the first mask (L) and the widest opening pattern of the second mask (R) overlap and are disposed in a straight line.

14. The method of claim 11, 12 or 13, wherein:
the opening patterns (L1-L12) of the first mask (L) are disposed at angles relative to a center of the first mask (L) and the opening patterns (R1-R12) of the second mask (R) are disposed at angles relative to a center of the second mask (R), and
the opening patterns (L1-L12) of the first mask (L) and the opening patterns (R1-R12) of the second mask (R) are left-right symmetrical.

15. The method of any of claims 11 to 14, wherein:
respective shapes of the opening patterns (R1-R12) of the second mask (R) are different from one another, and
an opening pattern of the second mask (R) is a polygon having a square shape or a curved shape.
